# EUROPEAN PATENT APPLICATION

(11) **EP 2 905 816 A1**
(43) Date of publication of application: **12.08.2015**
(21) Application number: 13843920.3
(22) Date of filing: 24.09.2013
(51) Int. Cl.: H01L 31/06

(54) **PHOTOVOLTAIC DEVICE AND METHOD FOR MANUFACTURING SAME**

(30) Priority: 04.10.2012 JP 2012222534
(71) Applicant: TOYOTA JIDOSHA KABUSHIKI KAISHA, Toyota-shi, Aichi-ken, 471-8571 (JP); The University of Tokyo, Tokyo 113-8654 (JP)
(72) Inventor: MASUDA, Taizo, Toyota-shi Aichi 471-8571 (JP); OKUMURA, Kenichi, Toyota-shi Aichi 471-8571 (JP); KONDO, Takashi, Tokyo 113-8654 (JP); MATSUSHITA, Tomonori, Tokyo 113-8654 (JP)
(74) Representative: TBK
(86) International application number: PCT/JP2013/075701
(87) International publication number: WO 2014/054457

(57) **Abstract**

Provided is a photovoltaic device prepared with a compound semiconductor, capable of reducing hazardous property and improving efficiency, and a method for manufacturing the photovoltaic device, the photovoltaic device including a photoelectric conversion layer including a compound semiconductor, a semiconductor layer layered on a surface of the photoelectric conversion layer, a contact layer arranged on the opposite side of the semiconductor layer to the photoelectric conversion layer, and an electrode layered on a surface of the contact layer, wherein the semiconductor layer includes a first crystal including Al, In, and P, and the contact layer includes a second crystal including Ge as a main component, and the method including the steps of vapor-depositing a photoelectric conversion layer including a compound semiconductor on a substrate, vapor-depositing a semiconductor layer including a first crystal including Al, In, and P, on a surface of the photoelectric conversion layer which is formed, vapor-depositing a contact layer having a second crystal including Ge as a main component, on an upper surface side of the semiconductor layer which is formed, and forming an electrode on a surface of the contact layer which is formed.

## Description

### TECHNICAL FIELD

The present invention relates to a photovoltaic device and a method for manufacturing the photovoltaic device.

### BACKGROUND ART

A solar cell has advantages that the amount of carbon dioxide emitted per power generation amount is small and it is not necessary to use fuel for power generation. Therefore, the solar cell is hoped as contributing to inhibiting global warming and the like. Currently, among consumer solar cells in practical use, a mono-junction solar cell having a pair of p-n junction and using a single-crystal silicon or a polycrystal silicon has become a mainstream. In order to improve performance of the solar cell, studies regarding solar cells having various configurations have been progressed.

Currently, a solar cell for space use prepared with a group III-V compound semiconductor has a performance more than twice as high as that of consumer solar cells. However, in spite of the good performance, the solar cell for space use has not been used as a consumer solar cell. One of the reasons is that a large amount of arsenic is contained in a contact layer and a power generation layer in the element of the solar cell. Since arsenic is a harmful substance, it is hoped that another substance is contained instead of arsenic in the consumer solar cell.

As a technique related to such a solar cell, for example Patent Literature 1 discloses a solar cell in which: a contact layer including GaP as a main component is layered on a surface of an AlInP window layer; and a surface electrode is layered on an upper surface of the contact layer. Patent Literature 2 discloses a group III-V solar cell (solar cell for space use) provided with a GaAs layer (cap layer) formed on a surface of an AlInP layer (window layer). The lattice constant of GaP is 0.5449 nm.

### Citation List

### Patent Literatures

Patent Literature 1: Japanese Patent Application Laid-Open No. 2007-115916
Patent Literature 2: Japanese Patent Application Laid-Open No. 2003-218374

### SUMMARY OF INVENTION

### Technical Problem

According to the technique disclosed in Patent Literature 1, it is possible to provide a solar cell including a contact layer not containing arsenic. However, since GaP and AlInP are largely different in their lattice constant, residual stress is generated at the interface between the contact layer (GaP) and the AlInP layer (semiconductor layer or window layer). Thus, the technique disclosed in Patent Literature 1 has a drawback that recombination loss is increased for example when the carrier generated at the power generation layer is moved to the electrode, whereby it is difficult to improve its performance. The technique disclosed in Patent Literature 2 can easily improve its performance, whereas hazardous property cannot be reduced.

Accordingly, an object of the present invention is to provide a photovoltaic device prepared with a compound semiconductor, capable of reducing hazardous property and improving efficiency, and a method for manufacturing the photovoltaic device.

### Solution to Problem

As a result of an intensive study, the inventors of the present invention have found out that it is possible to form a contact layer having a low residual stress generated at an interface, by containing Ge in the contact layer as a main component. Also, as a result of examining efficiency of a solar cell having a conventional structure in which GaAs is used for the contact layer and efficiency of a solar cell structured in the same manner as the conventional solar cell except that a contact layer containing Ge as a main component is used, the inventors have found out that the solar cell provided with the contact layer containing Ge as a main component has a same or improved performance compared to the conventional solar cell. Further, by preventing using a hazardous substance such as arsenic in a contact layer, it becomes also possible to reduce the hazardous property of a photovoltaic device. The present invention has been made based on the above findings.

In order to solve the above problems, the present invention takes the following means. Namely, a first aspect of the present invention is a photovoltaic device including a photoelectric conversion layer including a compound semiconductor, a semiconductor layer layered on a surface of the photoelectric conversion layer, a contact layer arranged on the opposite side of the semiconductor layer to the photoelectric conversion layer, and an electrode layered on a surface of the contact layer, wherein the semiconductor layer includes a first crystal including Al, In, and P, and the contact layer includes a second crystal including Ge as a main component.

In the first aspect of the present invention and other aspects of the present invention shown below (hereinafter these may be sometimes simply referred to as "the present invention" collectively), the term "semiconductor layer" corresponds to a so-called "window layer" when this layer is arranged on an upstream side of a traveling direction of the incident light on the photovoltaic device, and corresponds to a so-called "BSF layer" when this layer is arranged on a downstream side of the traveling direction of the incident light on the photovoltaic device. The lattice constant of the semiconductor layer can be changed by changing the composition ratio of elements that configure the semiconductor layer. In the present invention, the expression "including Ge as a main component" means that, determining the whole second crystal as 100 mass%, the second crystal contains 90 mass% or more of Ge. Also, in the present invention, the term "photovoltaic device" means a device which uses a photovoltaic force effect, and includes a solar cell, a light detector and the like. The lattice constant of the second crystal is approximately same as the lattice constant of the first crystal. Therefore, by having such a configuration, it is possible to largely reduce the residual stress to be generated at the interface between the contact layer and a layer in contact with the contact layer. By reducing the residual stress, it is possible to reduce the recombination loss; therefore it is possible to improve efficiency of the photovoltaic device. Further, by making the contact layer by Ge simple substance or a Ge compound, it is possible to reduce hazardous property.

In addition, in the first aspect of the present invention, the semiconductor layer and the contact layer may be in contact with each other. This makes it easy to shorten the distance between the photoelectric conversion layer and the electrode, whereby it becomes easy to improve efficiency of the photovoltaic device.

In addition, in the first aspect of the present invention, the lattice constant of the first crystal of the semiconductor layer is preferably 0.541 nm or more and 0.599 nm or less, and especially preferably 0.567 nm or more and 0.573 nm or less. This makes it easy to reduce the difference between the lattice constant of the semiconductor layer and the lattice constant of the contact layer. As a result, it becomes easy to reduce the residual stress, whereby it becomes easy to improve efficiency of the photovoltaic device.

In addition, in the first aspect of the present invention, the first crystal of the semiconductor layer may be an AlInP crystal. This also makes it possible to improve efficiency of the photovoltaic device while reducing the hazardous property.

In addition, in the first aspect of the present invention, the compound semiconductor may be a group III-V compound semiconductor. This also makes it possible to improve efficiency of the photovoltaic device while reducing the hazardous property.

A second aspect of the present invention is a method for manufacturing a photovoltaic device including a first vapor deposition step of vapor-depositing a photoelectric conversion layer including a compound semiconductor on a substrate, a second vapor deposition step of vapor-depositing a semiconductor layer including a first crystal including Al, In, and P on a surface of the photoelectric conversion layer which is formed, a third vapor deposition step of vapor-depositing a contact layer including a second crystal including Ge as a main component on an upper surface side of the semiconductor layer which is formed, and an electrode forming step of forming an electrode on a surface of the contact layer which is formed.

Since the lattice constant of the second crystal is nearly same as the lattice constant of the first crystal, it is possible to form a contact layer with which generation of the residual stress at the interface is reduced, in the third vapor deposition step. By reducing the residual stress, it is possible to reduce the recombination loss. Such a configuration makes it possible to manufacture a photovoltaic device with which efficiency is improved. Also, by making the contact layer by Ge simple substance or a Ge compound, it is also possible to reduce the hazardous property.

In addition, in the second aspect of the present invention, the third vapor deposition step may be a step of vapor-depositing the contact layer including the second crystal including Ge as a main component, on a surface of the semiconductor layer that is formed. This makes it easy to manufacture a photovoltaic device in which the distance between the photoelectric conversion layer and the electrode is short, whereby efficiency of the photovoltaic device can be improved.

In addition, in the second aspect of the present invention, the third vapor deposition step may be a step of vapor-depositing the contact layer by means of a molecular beam epitaxy, having a temperature of the substrate of 200°C or more. In a case where the contact layer is formed by vapor deposition by means of a molecular beam epitaxy, a contact layer which is a high-quality crystal layer having few defects can be easily formed, by having a temperature of the substrate of 200°C or more. Therefore, such a configuration makes it easy to improve efficiency of the photovoltaic device.

In addition, in the second aspect of the present invention, the third vapor deposition step may be a step of vapor-depositing the contact layer by means of a molecular beam epitaxy, having a temperature of the substrate of 200°C or more and 400°C or less. In a case where the contact layer is formed by vapor deposition by means of a molecular beam epitaxy, a contact layer which is a high-quality crystal layer having few defects can be easily formed, by having a temperature of the substrate of 200°C or more. Further, by making the temperature of the substrate 400°C or less, it becomes easy to inhibit diffusion of substances at the interface between the contact layer and the semiconductor layer, whereby the performance required for the contact layer can be easily secured. Therefore, such a configuration makes it easy to improve efficiency of the photovoltaic device.

In addition, in the second aspect of the present invention, the third vapor deposition step may be a step of vapor-depositing the contact layer by vapor deposition by means of a molecular beam epitaxy, having a molecular beam density of 7.0 x 10⁻⁶ Pa or less. In a case where the contact layer is formed by means of a molecular beam epitaxy, a contact layer which is a high-quality crystal layer having few defects is easily formed by making the molecular beam density of the raw material as 7.0×10⁻⁶ Pa or less. Therefore, such a configuration makes it easy to improve efficiency of the photovoltaic device.

In addition, the second aspect of the present invention preferably has, after the electrode forming step, a removal step of removing excess contact layer existing at a circumference of the electrode, by means of an alkali solution, while leaving the contact layer existing between the electrode and the semiconductor layer. Easiness of dissolution to an alkali solution of the semiconductor layer having the first crystal and that of the contact layer having the second crystal are different from each other. The former is difficult to dissolve and the latter is easy to dissolve to an alkali solution. Therefore, by using an alkali solution, leaving the semiconductor layer, it is possible to selectively and easily remove only the excess contact layer. Such a configuration makes it easy to manufacture a photovoltaic device having the above-mentioned effect.

In addition, in the second aspect of the present invention, the electrode forming step may have the steps of: forming a resist mask which corresponds to a shape of the electrode to be formed, on the surface of the contact layer; layering the electrode at least on the surface of the contact layer; and removing the resist mask existing at the circumference of the electrode in contact with the contact layer. Such a configuration also makes it possible to manufacture the photovoltaic device having the above-mentioned effects.

### Advantageous Effect of Invention

According to the present invention, it is possible to provide a photovoltaic device prepared with a compound semiconductor, capable of reducing the hazardous property and improving efficiency, and a manufacturing method of the photovoltaic device.

### BRIEF DESCRIPTION OF DRAWINGS

Fig. 1 is a view to explain a solar cell 10;
Fig. 2 is a flow chart to explain a manufacturing method of a photovoltaic device of the present invention;
Fig. 3 is a view to explain a molecular beams epitaxy apparatus.

### DESCRIPTION OF EMBODIMENTS

Hereinafter the present invention will be described with reference to the drawings. In the following explanation, an example in which the photovoltaic device is a solar cell and the manufacturing method of a photovoltaic device is a manufacturing method of the solar cell. However, the embodiments shown below are examples of the present invention, and the present invention is not limited to these embodiments.

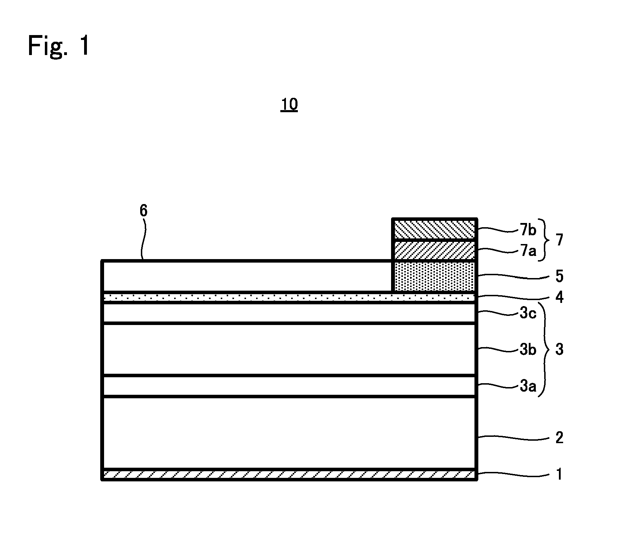

Fig. 1 is a view to explain a solar cell 10 which is one embodiment of the photovoltaic device of the present invention. In Fig. 1, light travels from an upper side (electrode 7 side) on the sheet of paper to a lower side of the sheet of paper (electrode 1 side).

As shown in Fig. 1, the solar cell 10 includes, in the order from a back surface side, an Al electrode 1, a p-type substrate 2 connected to the Al electrode 1, a photoelectric conversion layer 3 (power generation layer 3) arranged on a surface of the p-type substrate 2, a semiconductor layer 4 (hereinafter may be referred to as "window layer 4") arranged on a surface of the photoelectric conversion layer 3, a contact layer 5 and an antireflection film 6 that are arranged on a surface of the window layer 4, and an electrode 7 arranged on a surface of the contact layer 5. The p-type substrate 2 is a p-type Ge substrate, and the photoelectric conversion layer 3 includes three layers of three compound semiconductors of In, Ga, and P (a p-layer 3a, a p-layer 3b, and an n layer 3c). The p-layer 3a is in contact with the p-type substrate 2 and the p-layer 3b. The p-layer 3b is in contact with the p-layer 3a and the n layer 3c. The n-layer 3c is in contact with the p-layer 3b and the window layer 4. The window layer 4 is an n-type AlInP crystal layer, and the contact layer 5 in contact with an upper surface of the window layer 4 is an n-type Ge layer. The antireflection film 6 is arranged on a portion of the upper surface of the window layer 4, where the contact layer 5 is not arranged. The antireflection film 6 is a two-layered film of MgF₂/ZnS. The electrode 7 in contact with the upper surface of the contact layer 5 has a two-layer structure, and it has an electrode 7a which is a Ti layer in contact with the contact layer 5 and an electrode 7b which is an Au layer in contact with the electrode 7a.

The incident light on the solar cell 10 passes through the antireflection film 6 and the window film 4 to reach the photoelectric conversion layer 3. Then, the incident light is absorbed by the photoelectric conversion layer 3. In order for the window layer 4 not to inhibit the light absorption of the photoelectric conversion layer 3, the band gap of the window layer is adjusted so as to be same as or larger than the band gap of the photoelectric conversion layer 3. In the photoelectric conversion layer 3, a p-n junction is formed by the p-layer 3b and the n-layer 3c. Electrons generated by the photoelectric conversion layer absorbing light move to the n-layer 3c, and holes generated at the photoelectric conversion layer 3 move to the p-layer 3b. The electrons moved to the n-layer 3c reach the electrode 7 via the window layer 4 and the contact layer 5. The holes moved to the p layer 3b move to the p-layer 3a and the p-type substrate 2.

In order to improve efficiency of the solar cell 10, it is effective to increase the number of electrons that reach the electrode 7, and to reduce the resistance at contact interfaces of different layers. In order to increase the number of electrons that reach the electrode 7, it is effective to reduce the number of electrons to be lost on the way to electrode 7 from the photoelectric conversion layer 3. In order to reduce the number of electrons to be lost on the way, it is effective to reduce the residual stress to be generated at the interface between the window layer 4 and the contact layer 5. The residual stress is easy to be reduced in a case where the lattice constant of the crystal which makes a layer to be a foundation in forming the crystal layer and the lattice constant of the crystal layer to be formed are approximately same. In the solar cell 10, the lattice constant of the n-layer 3c is approximately same as the lattice constant of the window layer 4, and the lattice constant of the contact layer 5 is approximately same as the lattice constant of the window layer 4. Therefore, in the solar cell 10, it is possible to hardly generate the residual stress at the n-layer 3c, the window layer 4, and the contact layer 5, which makes it possible to improve efficiency.

In the solar cell 10, in order to reduce the resistance at the contact interfaces of the different layers, more specifically, the contact interfaces between the n-layer 3c and the window layer 4 and between the window layer 4 and the contact layer 5, it is effective to increase carrier concentrations of the n-layer 3c, the window layer 4, and the contact layer 5. In this regard, the carrier concentrations of the n-layer 3c, the window layer 4, and the contact layer 5 are increased by adjusting the amount of a dopant in producing the layers. Also, for the window layer 4, Ge which forms the contact layer 5 functions as an n-type dopant, and for the contact layer 5, P which diffuses most easily among the elements forming the window layer 4 functions as an n-type dopant. When a solar cell is manufactured, electrons easily diffuse from each layer, in a heating treatment carried out to form an electrode (heating treatment carried out to fit the electrode to the layer in contact therewith). Since Ge of the contact layer 5 functions as an n-type dopant in the window layer 4, and P of the window layer 4 functions as an n-type dopant in the contact layer 5, the resistance at the contact interface between the window 4 and the contact layer 5 is further reduced by this heating treatment.

As described above, according to the solar cell 10, it is possible to improve efficiency by increasing the number of electrons that reach the electrode 7, and by reducing the resistance at the contact interface. In addition, As which is a harmful substance is not used in the solar cell 10. Therefore, by having such a configuration, according to the present invention, the solar cell 10 prepared with a compound semiconductor, capable of reducing the hazardous property and improving efficiency can be provided.

The contact layer 5 (Ge crystal layer) used in the solar cell 10 has the following characteristics.
(1) Ge can realize a high carrier concentration with a group 13 element in the periodic table such as B (boron) and Al (aluminum), or a group 15 element in the periodic table such as P (phosphorus) added thereto. This makes it possible to reduce the resistance of the semiconductor layer (contact layer 5).
(2) By using an alkali solution, it is possible to dissolve only the contact layer 5, without dissolving the window layer 4. As a result, after forming the contact layer 5 and the electrode 7 on the upper surface of the window layer 4, the portion of the contact layer which is not sandwiched by the electrode 7 and the window layer 4 (contact layer existing at the circumference of the electrode 7) can be easily removed by means of an alkali solution, whereby the antireflection film 6 can be formed at the portion where the removed contact layer used to exist. This makes it easy to improve efficiency of the solar cell 10.
(3) The Ge crystal layer has an approximately same lattice constant as that of AlInP, and it can be formed by means of a molecular beam epitaxy (MBP) and metal organic chemical vapor deposition (MOCVD) that are common methods of manufacturing a compound semiconductor. That is, since it is possible to produce the photoelectric conversion layer 3, the window layer 4 and the contact layer 5 by means of a same apparatus, it is easy to manufacture the solar cell 10 in which efficiency can be improved.

In the present invention, the thickness and carrier concentration of each layer are not particularly limited. In view of easy improvement of the performance, the thickness and carrier concentration of each layer which configures the solar cell 10 can be within the following ranges for example. For example, the thickness of the Al electrode 1 can be 100 nm or more and 3000 nm or less; the thickness of the p-type substrate 2 can be 100 µm or more and 500 µm or less; the carrier concentration of the p-type substrate 2 can be 5 × 10¹⁸ cm⁻³ or more and 1 × 10²⁰ cm⁻³ or less.

The thickness of the p-layer 3a can be for example 20 nm or more, and more preferably 30 nm or more, in view of sufficient generation of an internal electric field. Also, the carrier concentration of the p-layer 3a can be 1 × 10¹⁷ cm⁻³ or more for example, and more preferably the same as or more of the carrier concentration of the p-layer 3b, in view of sufficient generation of an internal electric field.

The thickness of the p-layer 3b can be 500 nm or more for example, and more preferably 1500 nm or more, in view of having a configuration in which a sufficient light absorption is easy to be carried out. In addition, the thickness of the p-layer 3b is preferably 3000 nm or less, in view of movement of carrier generated by sunlight. The carrier concentration of the p-layer 3b can be 5 × 10¹⁶ cm⁻³ or more for example, and more preferably 1 × 10¹⁷ cm⁻³ or more, in view of reducing the internal resistance. The carrier concentration of the p-layer 3b can be 5 × 10¹⁸ cm⁻³ or less for example, and more preferably 1 × 10¹⁸ cm⁻³ or less, in view of reducing the recombination loss.

The thickness of the n-layer 3c can be 20 nm or more for example, and more preferably 30 nm or more, in view of sufficient generation of an internal electric field. In addition, the thickness of the n-layer 3c can be 200 nm or less for example, and preferably 100 nm or less, in view of reducing the moving distance of the carrier. The carrier concentration of the n-layer 3c can be 5 × 10¹⁷ cm⁻³ or more for example, and preferably 1 × 10¹⁸ cm⁻³ or more, in view of sufficient generation of an internal electric field. The carrier concentration of the n-layer 3c can be 1×10¹⁹ cm⁻³ or less for example, and preferably 7 × 10¹⁸ cm⁻³ or less, in view of reducing the recombination loss.

The thickness of the window layer 4 can be 10 nm or more for example, and preferably 20 nm or more, in view of forming a stable semiconductor layer. In addition, the thickness of the window layer 4 is preferably 50 nm or less, in view of securing the amount of light transmission. The carrier concentration of the window layer 4 can be 5 × 10¹⁷ cm⁻³ or more for example, and preferably same as or more than the carrier concentration of the n layer 3c, in view of reducing the internal resistance. However, in view of securing the light-transmissive property, the carrier concentration of the window layer 4 is preferably 1 × 10¹⁹ cm⁻³ or less.

The lattice constant of the window layer 4 can be changed by changing the composition ratio of the window layer. The lattice constant of the window layer 4 is preferably 0.541 nm or more and 0.599 nm or less, and especially preferably 0.567 nm or more and 0.573 nm or less, since the difference between the lattice constant of the window layer 4 and the lattice constant of Ge becomes small.

The thickness of the contact layer 5 can be 10 nm or more for example, and preferably 100 nm or more, in view of preventing short circuit due to a spike generated from the electrode. The thickness of the contact layer 5 can be 300 nm or less for example, and preferably 150 nm or less, in view of shortening manufacturing time. In addition, the carrier concentration of the contact layer 5 can be 1 × 10¹⁹ cm⁻³ or more for example, and preferably 5 × 10¹⁹ cm⁻³ or more, in view of reducing the contact resistance with the electrode.

The thickness of the antireflection film 6 can be 50 nm or more and 200 nm or less for example. Also, the thickness of the electrode 7a and the electrode 7b can be 20 nm or more and 3000 nm or less for example.

In the above explanation, a configuration in which the contact layer 5 is a Ge crystal layer is exemplified. However, the present invention is not limited to this configuration. The contact layer in the present invention is not limited as long as it includes the second crystal which contains Ge as a main component. Specifically, the contact layer is not limited as long as it includes the second crystal layer including 90 mass% or more of Ge, where the entire second crystal is determined as 100 mass%. In a case where the contact layer is formed by a Ge compound, for example Si and the like can be given as an element which can be contained in the contact layer together with Ge.

Also, in the above explanation, a configuration in which the window layer 4 is an AlInP crystal layer is exemplified. However, the present invention is not limited to this configuration. The window layer in the present invention is not limited as long as it includes the first crystal which contains Al, In, and P. An AlInP crystal, an AlInGaP crystal and the like can be exemplified as the first crystal. The lattice constants of the AlInP crystal and the AlInGaP crystal can be easily changed by changing a composition ratio of the constituent elements thereof. Both in a case where an AlInP crystal is used for the window layer and in a case where an AlInGaP crystal is used for the window layer, the photoelectric conversion layer can have a same configuration. In addition, in the present invention, a configuration in which both an AlInP crystal and an AlInGaP crystal are used for the window layer (for example a configuration in which an AlInGaP crystal is arranged on a photoelectric conversion layer side of the window layer, and an AlInP crystal is arranged on a contact layer side of the window layer side) can be applied.

In addition, in the above explanation, a configuration in which InGaP which is a group III-V compound semiconductor is used for the photoelectric conversion layer 3 is exemplified. However, the present invention is not limited to this configuration. For the photoelectric conversion layer in the present invention, for example another group III-V compound semiconductor such as InGaN can also be used. Further, the photoelectric conversion layer can be a multijunction type including a plurality of p-n junctions. In addition, for the photoelectric conversion layer of the present invention, a compound semiconductor other than the group III-V compound semiconductor can be used. However, it is preferable to use the group III-V compound semiconductor for the photoelectric conversion layer since the band gap can be changed according to the composition ratio of the material.

In addition, in the above explanation, a configuration in which the contact layer 5 and the electrode 7 having a two-layer structure are in contact with each other is exemplified. However, the present invention is not limited to this configuration. It should be noted that a substance having a good compatibility with the contact layer (e.g. Ti and Ag) is preferably used for the portion of the electrode layered on the surface of the contact layer where is to be in contact with the contact layer. In addition, in a case where the substance having a good compatibility with the contact layer to be used for the portion where is to be in contact with the contact layer is easy to be oxidized, it is preferable that the surface of the substance is covered by a conductive substance difficult to be oxidized.

In addition, in the above explanation, a configuration in which the antireflection film 6 is a two-layered film of MgF₂/ZnS is exemplified. However, the present invention is not limited to this configuration. The antireflection film can have another known configuration. In addition, a configuration in which the antireflection film is not provided can also be employed.

In addition, in the above explanation, a configuration in which the window layer 4 and the contact layer 5 are directly in contact with each other is exemplified. However, the present invention is not limited to this configuration. In the present invention, for example another layer can stand between the semiconductor layer and the contact layer, within a range in which efficiency is not inhibited.

In addition, in the above explanation, a configuration in which the window layer 4 is arranged on the surface of the photoelectric conversion layer 3, on the upstream side of the incident light, and the contact layer 5 is arranged on the surface of the window layer 4, on the upstream side of the incident light is exemplified. However, the present invention is not limited to this configuration. The "semiconductor layer layered on the surface of the photoelectric conversion layer" in the present invention can be layered on the surface of the photoelectric conversion layer, on downstream side of the incident light on the photoelectric conversion layer. Further, the "contact layer arranged on the opposite side of the semiconductor layer to the photoelectric conversion layer" can be layered on the surface of the semiconductor layer, on the downstream side of the incident light. In this case, the "semiconductor layer layered on the surface of the photoelectric conversion layer" corresponds to a so-called BSF layer. Such a configuration also makes it possible to reduce the hazardous property and improving efficiency.

In addition, in the above explanation, a configuration in which light is irradiated from an upper surface side of the photoelectric conversion layer 3 is exemplified. However, the present invention is not limited to this configuration. The photovoltaic device of the present invention can be a so-called double-sided light receiving type device. In a case where a double-sided light receiving type photovoltaic device is used for the present invention, the contact layer to be connected to the photoelectric conversion layer via the semiconductor layer can be arranged only on either one of light receiving surface sides of the photoelectric conversion layer, or can be arranged on both of the light receiving surface sides of the photoelectric conversion layer. Here, the expression "arranged on both of light receiving surface sides of the photoelectric conversion layer" means that the layers are arranged in the order in a layering direction of: the contact layer; the semiconductor layer; the photoelectric conversion layer; the semiconductor layer; and the contact layer.

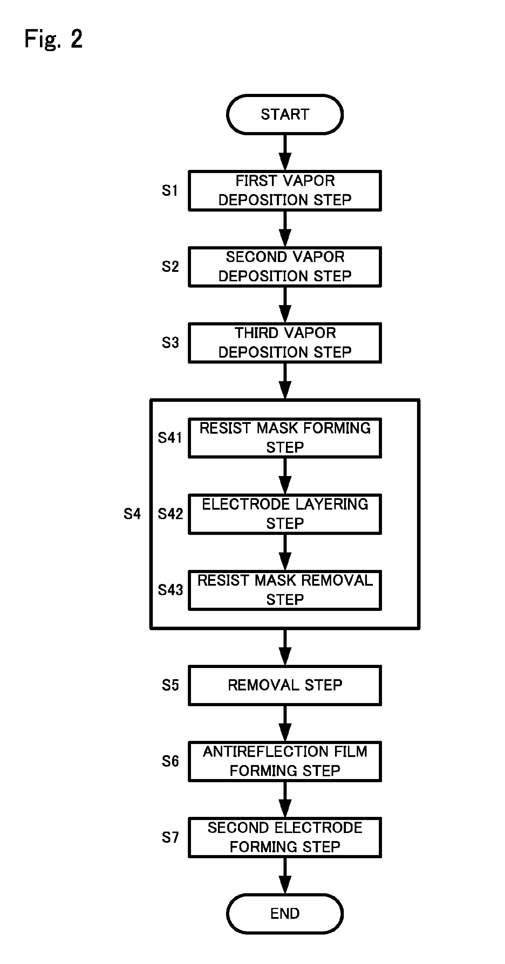

Fig. 2 is a flowchart to explain one embodiment of the method for manufacturing a photovoltaic device of the present invention (hereinafter the method may be referred to as "the manufacturing method of the present invention"). Hereinafter, with reference to Figs. 1 and 2, a specific example of the manufacturing method of the solar cell 10 will be described.

As shown in Fig.2 , the manufacturing method of the present invention includes a first vapor deposition step (S1), a second vapor deposition step (S2), a third vapor deposition step (S3), a first electrode forming step (S4), a removal step (S5), an antireflection film forming step (S6), and a second electrode forming step (S7). The first electrode forming step (S4) includes a resist mask forming step (S41), an electrode layering step (S42), and a resist mask removal step (S43).

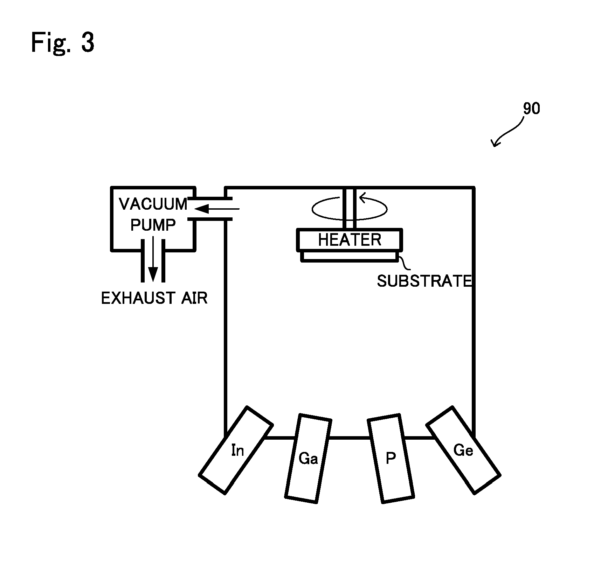

The first vapor deposition step (hereinafter the step may be referred to as "S1") is a step of forming the photoelectric conversion layer 3 on a surface of the p-type substrate 2, by means of a vapor deposition method. Fig. 3 shows a conceptual diagram of a molecular beam epitaxy apparatus 90 used in a molecular beam epitaxy.

When the p-layer 3a is formed on the surface of the p-type substrate 2, for example the p-layer 3a can be formed by means of a molecular beam epitaxy, by: making the temperature of the p-type substrate 2 500°C; heating a crucible which contains In, Ga, and P as raw materials; and irradiating the p-type substrate 2 at each molecular beam density of 4.0 × 10⁻⁵ Pa, 2.7 × 10⁻⁵ Pa, and 1.0 × 10⁻³ Pa. In this regard, Be is used as a p-type dopant, and the temperature of the crucible which contains Be is controlled so that Be has a desired carrier concentration (for example, controlled within a range of 700°C and 950°C).

When the p-layer 3b is formed on the surface of the p-layer 3a, the p-layer 3b can be formed by means of a molecular beam epitaxy, by: making the temperature of the p-type substrate 2 500°C; heating the crucible which contains In, Ga, and P as raw materials; and irradiating the p-layer 3a at each molecular beam density of 4.0 × 10⁻⁵ Pa, 2.7 × 10⁻⁵ Pa, and 1.0 × 10⁻³ Pa. In this regard, Be is used as a p-type dopant, and the temperature of the crucible which contains Be is controlled so that Be has a desired carrier concentration (for example, controlled within a range of 600°C and 850°C).

When the n-layer 3c is formed on the surface of the p-layer 3b, for example the n-layer 3c can be formed by means of a molecular beam epitaxy, by: making the temperature of the p-type substrate 2 500°C; heating the crucible which contains In, Ga, and P as raw materials; and irradiating the p-layer 3b at each molecular beam density of 4.0 × 10⁻⁵ Pa, 2.7 × 10⁻⁵ Pa, and 1.0 × 10⁻³ Pa. In this regard, Si is used as an n-type dopant, and the temperature of the crucible which contains Si is controlled so that Si has a desired carrier concentration (for example controlled within a range of 1000°C and 1350°C). In the manufacturing method of the present invention, by having these steps for example, it is possible to form the photoelectric conversion layer 3 on the surface of the p-type substrate 2.

The second vapor deposition step (hereinafter the step may be referred to as "S2") is a step of forming the window layer 4 by means of a vapor deposition method, on a surface of the photoelectric conversion layer 3 formed in S1. When the window layer 4 is formed on the surface of the photoelectric conversion layer 3 (surface of the n-layer 3c), for example the window layer 4 can be formed by means of a molecular beam epitaxy, by: making the temperature of the p-type substrate 2 500°C; heating the crucible which contains In, Al, and P as raw materials; and irradiating the n-layer 3c at each molecular beam density of 4.0 × 10⁻⁵ Pa, 1.3 × 10⁻⁵ Pa, and 1.0 × 10⁻³ Pa. In this regard, Si is used as an n-type dopant, and the temperature of the crucible which contains Si is controlled so that Si has a desired carrier concentration (for example, controlled within a range of 1000°C and 1350°C). In the manufacturing method of the present invention, the window layer 4 can be formed on the surface of the photoelectric conversion layer 3 (surface of the n-layer 3c) as above for example.

The third vapor deposition step (hereinafter the step may be referred to as "S3") is a step of forming the contacting layer 5 on a surface of the window layer 4 formed in S2, by means of a vapor deposition method. When the contact layer 5 is formed on the surface of the window layer 4, the contact layer 5 can be formed by means of a molecular beam epitaxy, by: making the temperature of the p-type substrate 2 200°C or more (preferably 200°C or more and 400°C or less); heating the crucible which contains Ge as a raw material; and irradiating the window layer 4 at a molecular beam density of 7.0 × 10⁻⁶ Pa or less, preferably 1.0 × 10⁻⁶ Pa or more and 7.0 × 10⁻⁶ Pa or less. In this regard, P is used as an n-type dopant, and the temperature of the crucible which contains P is controlled so that P has a desired carrier concentration (if GaP is used as a P source, the temperature is controlled within a range of 650°C and 900°C for example). In the manufacturing method of the present invention, the contact layer 5 can be formed on the surface of the window layer 4 as above for example.

If the temperature of the p-type substrate 2 is too low, the Ge layer does not become crystallized, and the layer may be formed having a lot of defects and implantations. Therefore, in view of easy formation of the contact layer 5 which is a high-quality Ge crystal layer, the temperature of the p-type substrate 2 is made to be 200°C or more in S3. On the other hand, in view of increasing crystallinity of the contact layer 5, the maximum value of the temperature of the p-type substrate 2 in forming the contact layer 5 is not particularly limited; however, if the temperature of the p-type substrate 2 is increased in forming the contact layer 5, electrons easily move between the window layer 4 and the contact layer 5. If GaAs is used for the contact layer as before, no problems occur since GaAs is a group III-V compound semiconductor. However, if Ge is used for the contact layer, it can cause a big problem. Among the constituent elements of the window layer 4, Al and In function as p-type dopants of the contact layer 5, and P functions as an n-type dopant of the contact layer 5. Therefore, if all these elements move from the window layer 4 to the contact layer 5, it tends to be difficult to control the carrier concentration and to control p/n types of the contact layer 5. Therefore, in view of easy control of carrier concentration and p/n types by reducing diffusion of atoms going to the contact layer 5, and as a result, making it possible to manufacture the solar cell 10 having a configuration in which the performance can be easily improved, it is preferable that the temperature of the p-type substrate 2 in forming the contact layer 5 is 400°C or less. By forming the contact layer 5 under this temperature condition, drive power of the heater can be reduced, whereby manufacturing cost of the solar cell can also be reduced.

In addition, if the molecular beam (vapor) density of Ge in forming the contact layer 5 is too large, the Ge layer is difficult to become crystallized. Therefore, in view of easy formation of the contact layer 5 which is a high-quality Ge crystal layer, the molecular beam density of Ge in S3 is set as 7.0 × 10⁻⁶ Pa or less. In contrast, the minimum value of the molecular beam density of Ge in S3 is not particularly limited; however, if the molecular beam density is too small, the manufacturing time tends to be longer. Therefore, in view of having a configuration in which the productivity is easy to be increased and the like, the molecular beam (vapor) density of Ge in forming the contact layer 5 is preferably 1.0 × 10⁻⁶ Pa or more.

The first electrode forming step (hereinafter the step may be referred to as "S4") is a step of forming the electrode 7 on a surface of the contact layer 5 formed in S3. When the electrode 7 is formed on the surface of the contact layer 5, firstly a layered body in which the photoelectric conversion layer 3, the window layer 4, and the contact layer 5, are layered on the surface of the p-type substrate 2 in the order mentioned is taken out from the molecular beam epitaxy apparatus; then, a resist mask which corresponds to the shape of the electrode 7 to be formed is produced on the surface of the contact layer 5, by means of a lithography process (resist mask forming step. Hereinafter the step may be referred to as "S41"). Here, the resist mask to be produced may be a positive mask or a negative mask. After the resist mask is produced in S41, Ti and Au are deposed on the surface of the contact layer 5 and the surface of the resist mask, in the order of deposing Ti first followed by deposing Au, by means of an deposition apparatus (electrode layering step. Hereinafter the step may be referred to as "S42"). After Ti and Au are deposed as above, the obtained layer body is taken out from the deposition apparatus, then immersed in an organic solvent (e.g. acetone solution) to dissolve the resist mask (resist mask removal step. Hereinafter the step may be referred to as "S43"). In S4, by having the above steps for example, the electrode 7 having a predetermined shape (e.g. comb-like shape) can be formed on the surface of the contact layer 5.

The removal step (hereinafter the step may be referred to as "S5") is a step of removing excessive portion of the contact layer (contact layer arranged on the portion where the electrode 7 does not exist on the upper side thereof), after forming the electrode 7 in S4. The excessive portion of the contact layer is removed in order for the contact layer 5 not to absorb light. By removing the excessive portion of the contact layer 5, the performance of the battery becomes easy to be improved. In removing the excessive portion of the contact layer, an alkali solution can be used. For example, an alkali solution produced by mixing aqueous ammonia, hydrogen peroxide water, and water so that their mass ratio is 2:1:20 can be used. Here, the contact layer dissolves in the alkali solution; however, the window layer is difficult to dissolve in the alkali solution. Therefore, in S5, by immersing the layered body in which the electrode 7 is formed in the alkali solution for a predetermined time (for example around 30 seconds), only the excessive contact layer can be selectively removed. After the excessive contact layer is selectively removed, the layered body is washed by water and subjected to a drying treatment.

The antireflection film forming step (hereinafter the step may be referred to as "S6") is a step of forming the antireflection film 6 at least on a part of the portion where the excessive contact layer removed in S5 used to exist. The antireflection film 6 can be formed by a known method.

The second electrode forming step (hereinafter the step may be referred to as "S7") is a step of forming the Al electrode 1 on a back surface side of the p-type substrate 2 (back surface side of the surface where the photoelectric conversion layer 3 is formed). The Al electrode 1 can be formed for example by means of a deposition apparatus. After the Al electrode 1 is formed as above, the Al electrode 1 is held in a predetermined temperature environment for a predetermined time, in order for the Al electrode 1 and p-type substrate 2 to fit to each other at the interface therebetween, and for the electrode 7 and the contact layer 5 to fit to each other at the interface therebetween. The temperature in holding can be around 400°C for example, and the holding time can be around 5 minutes for example. The solar cell 10 can be produced by going through the above steps.

For example by going though S1 to S7, the solar cell 10 can be manufactured. Therefore, according to the present invention, it is possible to provide a manufacturing method of a photovoltaic device, with which a photovoltaic device prepared with a compound semiconductor and capable of reducing the hazardous property and improving efficiency can be manufactured.

In the above explanation regarding the manufacturing method of the present invention, a configuration in which the solar cell 10 is manufactured by means of a molecular beam epitaxy is exemplified. However, the present invention is not limited to this configuration. The manufacturing method of the present invention can have a configuration in which a vapor deposition method other than molecular beam epitaxy, such as a metal organic chemical vapor deposition method (MOCVD) is used.

In the above explanation regarding the present invention, a configuration in which both the window layer 4 and the contact layer 5 are n-type layers is exemplified. However, the present invention is not limited to this configuration. The present invention can have a configuration in which the window layer and the contact layer are p-type layers.

### Description of Reference Numerals

- 1: electrode
- 2: p-type substrate (substrate)
- 3: photoelectric conversion layer
- 4: window layer (semiconductor layer)
- 5: contact layer
- 6: antireflection film
- 7: electrode
- 10: solar cell (photovoltaic device)
- S1: first vapor deposition step
- S2: second vapor deposition step
- S3: third vapor deposition step
- S4: first electrode forming step (electrode forming step)
- S41: resist mask forming step
- S42: electrode layering step
- S43: resist mask removal step
- S5: removal step
- S6: antireflection film forming step
- S7: second electrode forming step

## Claims

1. A photovoltaic device comprising:
a photoelectric conversion layer comprising a compound semiconductor;
a semiconductor layer layered on a surface of the photoelectric conversion layer;
a contact layer arranged on an opposite side of the semiconductor layer to the photoelectric conversion layer; and
an electrode layered on a surface of the contact layer, wherein the semiconductor layer comprises a first crystal comprising Al, In, and P, and the contact layer comprises a second crystal comprising Ge as a main component.

2. The photovoltaic device according to claim 1, wherein the semiconductor layer and the contact layer are in contact with each other.

3. The photovoltaic device according to claim 1 or 2, wherein a lattice constant of the first crystal of the semiconductor layer is 0.567 nm or more and 0.573 nm or less.

4. The photovoltaic device according to any one of claims 1 to 3, wherein the first crystal of the semiconductor layer is an AlInP crystal.

5. The photovoltaic device according to any one of claims 1 to 4, wherein the compound semiconductor is a group III-V compound semiconductor.

6. A method for manufacturing a photovoltaic device comprising:
a first vapor deposition step of vapor-depositing a photoelectric conversion layer comprising a compound semiconductor on a substrate;
a second vapor deposition step of vapor-depositing a semiconductor layer comprising a first crystal comprising Al, In, and P, on a surface of the photoelectric conversion layer which is formed;
a third vapor deposition step of vapor-depositing a contact layer comprising a second crystal comprising Ge as a main component, on an upper surface side of the semiconductor layer which is formed; and
an electrode forming step of forming an electrode on a surface of the contact layer which is formed.

7. The method for manufacturing a photovoltaic device according to claim 6, wherein the third vapor deposition step is a step of vapor-depositing the contact layer comprising the second crystal comprising Ge as a main component on a surface of the semiconductor layer.

8. The method for manufacturing a photovoltaic device according to claim 6 or 7, wherein the third vapor deposition step is a step of vapor-depositing the contact layer by means of a molecular beam epitaxy, having a temperature of the substrate of 200°C or more.

9. The method for manufacturing a photovoltaic device according to claim 6 or 7, wherein the third vapor deposition step is a step of vapor-depositing the contact layer by means of a molecular beam epitaxy, having a temperature of the substrate of 200°C or more and 400°C or less.

10. The method for manufacturing a photovoltaic device according to any one of claims 6 to 9, wherein the third vapor deposition step is a step of vapor-depositing the contact layer by means of a molecular beam epitaxy, having a molecular beam density of 7.0 × 10⁻⁶ Pa or less.

11. The method for manufacturing a photovoltaic device according to any one of claims 6 to 10, the method comprising a removal step of removing the contact layer existing at a circumference of the electrode by means of an alkali solution, while leaving the contact layer existing between the electrode and the semiconductor layer.

12. The method for manufacturing a photovoltaic device according to any one of claims 6 to 11, wherein the electrode forming step comprises the steps of:
on the surface of the contact layer, forming a resist mask which corresponds to a shape of the electrode to be formed;
layering the electrode at least on the surface of the contact layer; and
removing the resist mask existing at a circumference of the electrode in contact with the contact layer.
